# EUROPÄISCHE PATENTSCHRIFT

(11) **EP 1 926 355 B1**
(45) Veröffentlichungstag und Bekanntmachung des Hinweises auf die Patenterteilung: **08.01.2014**
(21) Anmeldenummer: 07076013.7
(22) Anmeldetag: 21.11.2007
(51) Int. Cl.: H05K 3/00, H05K 1/00

(54) **Verfahren zum Herstellen eines dehnbaren Schaltungsträgers und dehnbarer Schaltungsträger**
Method for manufacturing an extendable circuit support and extendable circuit support
Procédé de fabrication d'un support de circuit extensible et support de circuit extensible

(30) Priorität: 21.11.2006 DE 102006055576
(43) Veröffentlichungstag der Anmeldung: 28.05.2008
(73) Patentinhaber: Fraunhofer-Gesellschaft zur Förderung der angewandten Forschung e.V., 80686 München (DE)
(72) Erfinder: Ostmann, Andreas, 10585 Berlin (DE); Seckel, Manuel, 10559 Berlin (DE); Löher, Thomas, 10961 Berlin (DE); Manessis, Dionysios, 10707 Berlin (DE); Patzelt, Rainer, 10243 Berlin (DE)
(74) Vertreter: Pfenning, Meinig & Partner GbR

(56) Entgegenhaltungen:
- DE-A1-102006 021 765
- DE-U1- 20 320 760
- US-A1- 2003 025 824
- US-A1- 2004 238 819
- US-A1- 2005 019 554
- US-A1- 2005 282 410
- US-A1- 2006 231 288

## Beschreibung

Die vorliegende Erfindung betrifft ein Verfahren zum Herstellen eines dehnbaren Schaltungsträgers sowie einen entsprechenden dehnbaren Schaltungsträger.

Dehnbare Schaltungsträger können insbesondere im medizintechnischen Bereich Anwendung finden, wenn es gilt, Schaltungsträger und gegebenenfalls mit den Schaltungsträgern verbundene elektronische Bauteile beispielsweise an oder in einem lebenden Körper an Oberflächen mit dreidimensionaler Topographie anzuordnen. Weiter Anwendungen können sich durch eine Integration von Schaltungsträgern in designerisch anspruchsvollen Umgebungen, beispielsweise in Fahrzeuginnenräumen, ergeben.

Dehnbare Schaltungsträger sind z.B. aus der Druckschrift US 2004/0238819 A1 an sich bekannt, zeichnen sich aber bislang durch eine ausgesprochen aufwendige Herstellung aus. Der vorliegenden Erfindung liegt also die Aufgabe zugrunde, ein Verfahren zum Herstellen eines dehnbaren Schaltungsträgers zu entwickeln, das eine vergleichsweise aufwandsarme und damit kostengünstige Herstellung solcher Schaltungsträger ermöglicht. Der Erfindung liegt ferner die Aufgabe zugrunde, dementsprechend einfach herstellbare dehnbare Schaltungsträger zu entwickeln, die zusätzlich zu einer Leiterstruktur auch mindestens ein elektronisches Bauelement umfassen und ohne Beschädigungen auch mehrfach gedehnt und wieder entspannt werden können.

Diese Aufgabe wird erfindungsgemäß gelöst durch ein Verfahren mit den Merkmalen des Anspruchs 1 sowie durch einen dehnbaren Schaltungsträger mit den Merkmalen des Anspruchs 17. Vorteilhafte Ausgestaltungen und Weiterentwickelungen der Erfindung ergeben sich mit den Merkmalen der Unteransprüche.

Das vorgeschlagene Verfahren lässt sich dadurch sehr einfach durchführen, dass ein Ausgangsmaterial für ein dehnbares Substrat auf eine zunächst vollflächig vorliegende Folie aufgebracht wird, welches dann eine mit der Folie verbundene, also auf der Folie haftende, dehnbare Substratschicht bildet, wonach die Folie so strukturiert wird, dass sie eine Leiterstruktur mit mindestens einer dehnbaren Leiterbahn bildet.

Dabei kann die Substratschicht durch Verwendung eines entsprechenden Ausgangsmaterials, das auch aus mehreren Komponenten bestehen kann, insbesondere aus einem vorzugsweise thermoplastischen Polyurethan oder aus Silikon oder Kautschuk oder Latex oder einem anderen dehnbaren, gummiartigen Polymer gebildet werden. Das Bilden der dehnbaren Substratschicht kann dabei durch ein Aushärten, beispielsweise ein Vernetzen oder Abbinden, des Ausgangsmaterials geschehen, bei dem dieses in einen dehnbaren Endzustand übergeht. Das Aushärten kann bei verschiedenen Ausführungen der Erfindung thermisch oder chemisch ausgelöst werden. In einem besonders einfachen Fall wird ein thermoplastisches Ausgangsmaterial zum Bilden der Substratschicht verwendet, das durch Auskühlen aushärtet und in seinen dehnbaren Endzustand übergeht.

Die dehnbare Substratschicht kann dabei beispielsweise eine vorzugsweise gleichmäßige Dicke von zwischen 25 µm und 1 mm erhalten, wobei sich eine vorteilhaft leichte Dehnbarkeit bei nicht zu geringer Belastbarkeit insbesondere dann ergeben kann, wenn die dehnbare Substratschicht mit einer Dicke von zwischen 25 µm und 200 µm ausgeführt wird. In beschriebener Weise ist es problemlos möglich, eine Substratschicht und damit einen Schaltungsträger zu realisieren, die sich um mindestens 10 %, vorzugsweise um mindestens 50 %, das heißt auf mindestens 110 % bzw. 150 % einer Ausgangslänge, ausdehnen lassen, wobei auch ein mehrfaches Dehnen und Entspannen der Schaltungsträgers keine Beschädigungen bewirkt.

Das Ausgangsmaterial zum Bilden der dehnbaren Substratschicht kann in einfacher Weise durch Rakeln oder Drucken, insbesondere durch Siebdruck, der wiederum mit Hilfe eines Rakels durchgeführt werden kann, oder durch Gießen oder Laminieren auf die Folie aufgebracht werden. Im Fall eines Aufbringens des Ausgangsmaterials durch Laminieren kann das Ausgangsmaterial beispielsweise in Form von Pulver oder auch in Folienform auf die die Leiterstruktur bildende Folie aufgetragen werden, um dann vorzugsweise unter Einwirkung von Druck und/oder Temperatur - beispielsweise mittels einer Walze (durch Rollenlaminieren) -, mit der leitenden Folie verbunden zu werden.

Um eine bessere Haftung der dehnbaren Substratschicht auf der leitenden Folie zu erreichen, kann die Folie vor dem Auftragen des Ausgangsmaterials an einer später der Substratschicht zugewandten Oberfläche chemisch oder mechanisch aufgerauht und/oder oxidiert werden.

Die leitende Folie, die mit Blick auf eine gute Leitfähigkeit aus Kupfer oder auch aus Gold oder Silber oder einem anderen Metall gebildet sein kann, kann im Hinblick auf möglichst geringe Abmessungen des Schaltungsträgers bei einer nicht zu großen Empfindlichkeit der mindestens einen Leiterbahn beispielsweise mit einer Dicke von zwischen 5 µm und 100 µm gewählt werden. Das Strukturieren dieser Folie zum Bilden der Leiterstruktur kann dabei in an sich bekannter Weise geschehen, beispielsweise durch Photolithographie. Um zu gewährleisten, dass die mindestens eine Leiterbahn dehnbar ist, kann es vorgesehen sein, dass die Leiterbahn dabei einen alternierend in einander gegenüberliegende Richtungen aus einer Hauptleiterrichtung herausgekrümmten, also typischerweise einen wellenförmigen, zickzack-förmigen oder mäanderförmigen Verlauf erhält. Um ein Brechen der mindestens einen Leiterbahn bei einem Dehnen des so hergestellten Schaltungsträgers zu vermeiden, sollten Richtungsänderungen des Verlaufs der Leiterbahnen dabei möglichst gerundet geformt sein.

Es kann vorgesehen sein, dass nach dem Strukturieren der Folie eine die Leiterstruktur überdeckende zweite dehnbare Schicht auf die Leiterstruktur und auf freigelegte Bereiche der zuerst genannten dehnbaren Substratschicht aufgebracht wird, die dadurch mit der dehnbaren Substratschicht zusammen ein Substrat bildet, in dem die Leiterstruktur eingebettet und so geschützt liegt. Zur Herstellung der zweiten dehnbaren Schicht können dabei wieder alle weiter oben als mögliche Ausgangsmaterialien für die dehnbare Substratschicht genannten Materialien verwendet werden. Dabei kann das gleiche oder ein anderes Material verwendet werden als für die dehnbare Substratschicht. Zum Auftragen des entsprechenden Materials kommen die schon genannten Verfahren in Frage, also insbesondere Drucken, Rakeln, Gießen oder Laminieren.

Erfindungsgemäß umfasst die Leiterstruktur neben der mindestens einen Leiterbahn - normalerweise werden mehrere dehnbare Leiterbahnen vorgesehen sein - auch Anschlussflächen, die zum Kontaktieren von mit der Leiterstruktur zu verbindenden elektronischen Bauelementen geeignet sind. Dabei ist es besonders vorteilhaft, dass zusätzlich zu den Leiterbahnen mit den Anschlussflächen, die jeweils mit einer dehnbaren Leiterbahn verbunden sind, Verstärkungsstrukturen in die Folie einstrukturiert werden, die die Substratschicht in einer Umgebung mindestens zweier Anschlussflächen versteifen, ohne diese Anschlussflächen elektrisch miteinander zu verbinden. Dabei kann eine mechanische Überbelastung von elektrischen Verbindungen zwischen den Anschlussflächen und Anschlüssen eines mit den Anschlussflächen kontaktierten elektronischen Bauelements und eine den Kontakt unterbrechende Beschädigung dieser Verbindungen vermieden werden. Bei den Verstärkungsstrukturen kann es sich dabei beispielsweise um VersteifungsPads oder Versteifungsflächen handeln, die in der Umgebung der entsprechenden Anschlussflächen angeordnet und vorzugsweise ringsherum isoliert sind.

Eine vorteilhafte Ausgestaltung des Verfahrens sieht vor, dass der damit hergestellte Schaltungsträger mindestens ein mit der Leiterstruktur verbundenes elektronisches Bauelement umfasst und so eine dehnbare komplexe elektronische Struktur bildet. Dabei können verschiedene elektronische Bauelemente verwendet werden, beispielsweise aktive oder passive oberflächenmontierte Bauelemente oder in Flip-Chip-Technik montierte integrierte Schaltkreise. Auch kann es sich bei dem mindestens einen elektronischen Bauelement um einen Sensor handeln.

Ein solches elektronisches Bauelement kann auf verschiedene Weisen in den dehnbaren Schaltungsträger integriert werden. Beispielsweise kann es vorgesehen sein, dass die Leiterstruktur nach dem Strukturieren der Folie mit dem mindestens einen elektronischen Bauelement bestückt wird, wobei eine Verbindung mit der Leiterstruktur in an sich bekannter Weise, beispielsweise mittels eines leitfähigen Klebstoffs, geschehen kann. In diesem Fall ist es besonders vorteilhaft, wenn anschließend eine die Leiterstruktur überdeckende zweite dehnbare Schicht aufgebracht wird, in die dann auch das mindestens eine elektronische Bauelement teilweise oder vollständig eingebettet werden kann. Um Kontaktierungen zwischen dem elektronischen Bauelement und der Leiterstruktur vor Überlastungen bei einem Dehnen des dehnbaren Schaltungsträgers zu schützen, kann das elektronische Bauelement nach einem Kontaktieren mit der Leiterstruktur mit einem Material umgeben werden, welches das elektronische Bauelement mit der dehnbaren Substratschicht und der Leiterstruktur in einer Umgebung des elektronischen Bauelements verbindet und das, gegebenenfalls nach einem Aushärten, steifer ist als die dehnbare Substratschicht. Dazu kann das elektronische Bauelement beispielsweise mit dem genannten Material umgossen werden. Die genannte zweite dehnbare Schicht kann gegebenenfalls anschließend aufgebracht werden. Auch das genannte steifere Material wird dabei üblicherweise durch ein Polymer gegeben sein.

Wenn die Leiterstruktur in beschriebener Weise nach dem Strukturieren der Folie mit dem elektronischen Bauelement oder mehreren Bauelementen bestückt wird und eine anschließend aufgebrachte, die Leiterstruktur überdeckende zweite dehnbare Schicht vorgesehen ist, kann es vorteilhaft sein, die zweite dehnbare Schicht bei einer niedrigeren Temperatur aufzubringen als das die Substratschicht bildende Ausgangsmaterial. So kann es beispielsweise vorgesehen sein, als Ausgangsmaterial für die dehnbare Substratschicht ein Thermoplast einer Schmelztemperatur von größer als 200° C zu verwenden, während die zweite dehnbare Schicht aus einem thermoplastischen Kunststoff mit einer Schmelztemperatur von weniger als 130° C gebildet wird. Dadurch kann erreicht werden, dass einerseits die dehnbare Substratschicht beim Bestücken der Leiterstruktur mit dem elektronischen Bauelement nicht beschädigt wird - selbst dann, wenn dazu beispielsweise ein Lötprozess durchgeführt wird -, während andererseits durch die niedrigere Temperatur beim Aufbringen der zweiten dehnbaren Schicht eine Beschädigung der Verbindung des elektronischen Bauelements mit der Leiterstruktur verhindert wird. In dieser Hinsicht ist es besonders vorteilhaft, wenn die dehnbare Substratschicht Temperaturen von etwa 200° C beschädigungsfrei aushalten kann, während die zweite dehnbare Schicht bei einer Temperatur von höchstens 130° C aufgetragen wird.

Ein anderes Verfahren zur Realisierung eines dehnbaren Schaltungsträgers mit mindestens einem elektronischen Bauelement sieht vor, dass schon vor dem Aufbringen des Ausgangsmaterials auf die Folie das mindestens eine elektronische Bauelement so auf der Folie angeordnet und mit der Folie verbunden wird, dass das mindestens eine elektronische Bauelement beim Aufbringen des Ausgangsmaterials zumindest teilweise in die entstehende dehnbare Substratschicht eingebettet wird, wobei das Ausgangsmaterial das elektronische Bauelement vorzugsweise vollständig überdecken sollte. Eine leitende Verbindung von Anschlüssen des elektronischen Bauelements mit der Folie kann dabei wieder in an sich bekannter Weise hergestellt werden, beispielsweise durch Ankleben mit einem leitfähigen Klebstoff oder auch durch Anlöten oder Anschweißen, insbesondere durch Pressschweißen oder Diffusionsbonden. Vorteilhafter Weise kann dabei auch bei einer Anwendung höherer Temperaturen beim Verbinden des elektronischen Bauelements mit der Folie keine Beschädigung der dehnbaren Substratschicht erfolgen, weil diese erst später aufgetragen wird. Das Strukturieren der Folie zum Herstellen der Leiterstruktur geschieht dagegen wieder erst nach dem Aufbringen der dehnbaren Substratschicht, wobei die Leiterstruktur wiederum dadurch geschützt werden kann, dass anschließend noch eine die Leiterstruktur überdeckende zweite dehnbare Schicht aufgebracht wird.

Wenn bei dem im vorherigen Absatz beschriebenen Verfahren das mindestens eine auf der Folie angeordnete elektronische Bauelement vor dem Aufbringen des Ausgangsmaterials zur Bildung der dehnbaren Substratschicht mit einem Material umgeben wird, das das elektronische Bauelement mechanisch mit der Folie verbindet und das - gegebenenfalls nach einem Aushärten - steifer ist als die dehnbare Substratschicht, kann wieder in einfacher Weise ein Schutz von Kontaktierungen zwischen dem elektronischen Bauelement und der später entstehenden Leiterstruktur vermieden werden. Bei einer vorteilhafter Ausgestaltung des Verfahrens kann vorgesehen sein, dass die Folie vor dem Anordnen des mindestens einen elektronischen Bauelements auf der Folie mit beispielsweise durch Vertiefungen gegebenen Positionsmarkierungen und/oder mit Orientierungsbohrungen versehen wird, beispielsweise durch eine Behandlung mit Laserstrahlung, wonach das mindestens eine elektronische Bauelement an den Positionsmarkierungen und/oder in definierter Position relativ zu den Orientierungsbohrungen angeordnet wird. Das kann eine richtige Anordnung des elektronischen Bauelements oder der elektronischen Bauelemente erleichtern angesichts der Tatsache, dass die Leiterstruktur dann noch nicht fertiggestellt ist. Geeignet geformte Positionsmarkierungen können dabei - insbesondere bei einem Lötprozess - in vorteilhafter Weise auch eine Selbstzentrierung des elektronischen Bauelements beim Verbinden mit der Folie bewirken. Orientierungsbohrungen, die die Folie vollständig durchstoßen oder zumindest an einer Rückseite der Folie erkennbar sind, können ferner in vorteilhafter Weise beim Strukturieren der Folie zur Bildung der Leiterstruktur als Orientierung dienen.

Unter Umständen ist es auch möglich, die zwei verschiedenen zum Integrieren von elektronischen Bauelementen in oder auf einem dehnbaren Schaltungsträgersubstrat beschriebenen Verfahren so zu kombinieren, dass ein elektronisches Bauelement oder mehrere elektronische Bauelemente vor dem Aufbringen des Ausgangsmaterials zum Bilden der dehnbaren Substratschicht mit der noch unstrukturierten Folie verbunden und anschließend in die dehnbare Substratschicht eingebettet werden, während mindestens ein weiteres elektronisches Bauelement nach dem Strukturieren der Folie auf der Gegenüberliegenden Seite mit der Leiterstruktur verbunden und gegebenenfalls durch eine zweite dehnbare Schicht überdeckt wird.

Unabhängig von dem gewählten Verfahren können schließlich Anschlüsse des mindestens einem elektronischen Bauelements nicht nur direkt, sondern auch mittels eines leitfähigen dehnbaren Materials mit Anschlussflächen (Pads genannt) der Leiterstruktur verbunden werden. Im Fall einer Montage des elektronischen Bauelements auf der noch nicht strukturierten Folie kann das wiederum vor dem Aufbringen des Ausgangsmaterials für die dehnbare Substratschicht - das gilt insbesondere für den Fall, dass das elektronische Bauelement der Folie abgewandte Anschlüsse aufweist - oder nach einem Strukturieren der Folie geschehen. Eine dadurch erreichte elastische Kontaktierung des elektronischen Bauelements kann eine Beschädigung der leitenden Verbindung des elektronischen Bauelements mit der Leiterstruktur bei einem Dehnen des dehnbaren Schaltungsträgers vermeiden helfen. Bei dem leitfähigen dehnbaren Material kann es sich beispielsweise um einen mit leitenden Partikeln oder Fasern gefüllten gummiartigen Kunststoff handeln.

Besonders vorteilhafte dehnbare Schaltungsträger, die sich beispielsweise in beschriebener Weise herstellen lassen, umfassen demnach ein dehnbares Substrat, eine in das Substrat eingebettete oder an einer Oberfläche des Substrats angeordnete Leiterstruktur mit dehnbaren Leiterbahnen und mindestens zwei jeweils mit einer der Leiterbahnen verbundenen Anschlussflächen sowie mindestens ein elektronisches Bauelement, das mit den Anschlussflächen elektrisch leitend verbundene Anschlüsse aufweist, wobei die Leiterstruktur Verstärkungsstrukturen aufweist, die den Schaltungsträger in einer Umgebung der mit dem mindestens einen elektronischen Bauelement verbundenen Anschlussflächen versteift, ohne die Anschlussflächen elektrisch zu verbinden. Zusätzlich kann er vorgesehen sein, dass
- das mindestens eine elektronische Bauelement mit einem es mechanisch mit der Leiterstruktur verbindenden Material umgeben ist, das steifer ist als das ein das dehnbare Substrat bildendes Material, und/oder
- mindestens einer der Anschlüsse des mindestens einen elektronischen Bauelements mittels eines leitfähigen dehnbaren Materials mit der entsprechenden Anschlussfläche verbunden ist.
   Die genannten Merkmale dienen dabei insbesondere dazu, Kontaktierungen zwischen dem mindestens einen elektronischen Bauelement und der Leiterstruktur vor Beschädigungen auch bei einem gegebenenfalls mehrfachen Dehnen und Relaxieren des dehnbaren Schaltungsträgers zu verhindern. Ein solcher dehnbarer Schaltungsträger kann zusätzlich selbstverständlich alle möglichen Kombinationen der Merkmale aufweisen, die sich aus den zuvor beschriebenen Ausgestaltungen des entsprechenden Herstellungsverfahrens ergeben.
   Dehnbare Schaltungsträger der zuletzt beschriebenen Art können schließlich sogar vollständig dehnbare autonome elektronische Gesamtsysteme - beispielsweise Sensor, Prozessor, Datenübertragungsmittel und Energieversorgung umfassend - bilden und insbesondere dann besonders vorteilhaft sein, wenn eine Datenverarbeitung möglichst nah an einem Sensor erfolgen soll und eventuell anschließend ein drahtloser Datentransfer zu einer Kontrollstelle vorgesehen ist.
   Ausführungsbeispiele der vorliegenden Erfindung werden nachfolgend anhand der vorliegenden Figuren 1 bis 8 beschrieben. Es zeigt
   - Fig. 1: einen Querschnitt durch eine Kupferfolie bei einem ersten Schritt eines erfindungsgemäßen Verfahrens,
   - Fig. 2: in entsprechender Darstellung einen ersten Verfahrensschritt bei einer alternativen Gestaltung des Verfahrens,
   - Fig. 3: eine Aufsicht auf einen bei dem Verfahren entstehenden dehnbaren Schaltungsträger nach einem weiteren Verfahrensschritt,
   - Fig. 4: wieder einen Querschnitt durch denselben Schaltungsträger nach abschließenden Verfahrensschritten,
   - Fig. 5: einen Querschnitt durch eine Kupferfolie bei einem ersten Verfahrensschritt eines Verfahrens zum Herstellen eines dehnbaren Schaltungsträgers in einer anderen Ausführung der Erfindung,
   - Fig. 6: in entsprechender Darstellung den entstehenden Schaltungsträger nach darauf folgenden Verfahrensschritten desselben Verfahrens,
   - Fig. 7: denselben entstehenden Schaltungsträger nach einem Aufbringen einer dehnbaren Substratschicht und
   - Fig. 8: wieder eine Querschnittsdarstellung desselben entstehenden dehnbaren Schaltungsträgers nach einer Strukturierung der Kupferfolie.

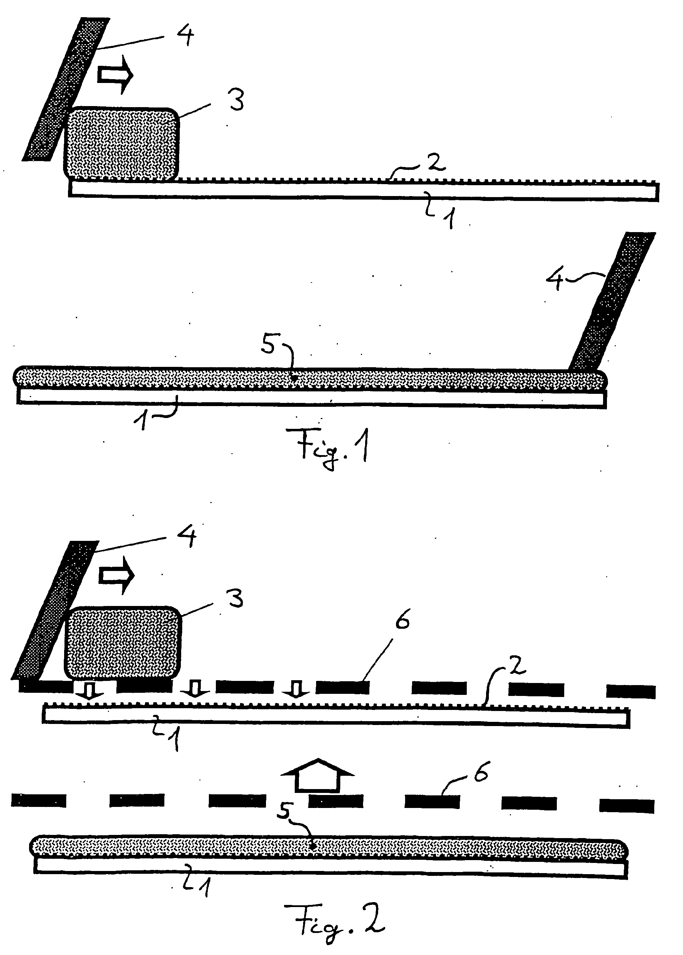

In Fig. 1 ist eine etwa 35 µm dicke Folie 1 aus Kupfer zu erkennen, die an einer oberen Oberfläche 2 zuvor chemisch oder mechanisch aufgerauht worden und oxidiert ist. Für das beschriebene Verfahren könnten in gleicher Weise auch andere Metallfolien, beispielsweise aus Gold oder Silber, verwendet werden. Auch könnte die Folie 1 dicker oder dünner sein und insbesondere eine Dicke von 70 µm oder 18 µm haben. Die Folie 1 ist in Fig. 1 einmal (oben) vor einem ersten Verfahrensschritt und einmal (unten) nach diesem Verfahrensschritt dargestellt, während dessen ein Ausgangsmaterial 3, bei dem es sich hier um ein thermoplastisches Polyurethan handelt, mittels eines Rakels 4 auf die elektrisch leitende Folie 1 aufgebracht wird. Nach einem Abbinden des Ausgangsmaterials 3 bildet dieses eine fest mit der Folie 1 verbundene dehnbare Substratschicht 5. Anstelle des genannten thermoplastischen Polyurethans können auch andere Polyurethane, Silikon, Kautschuk oder Latex und allgemein solche elektrisch isolierende Stoffe als Ausgangsmaterial 3 verwendet werden, die nach einem Aushärten in einen dehnbaren Endzustand übergehen. Die dehnbare Substratschicht 5 hat im vorliegenden Ausführungsbeispiel eine Dicke von etwa 35 µm.

Der beschriebene Verfahrensschritt kann auch in abgewandelter Form durchgeführt werden. Insbesondere kann das Ausgangsmaterial 3, wie in Fig. 2 entsprechend dargestellt, durch Siebdruck auf die Folie 1 aufgebracht werden, indem es wieder mit Hilfe eines Rakels 4 durch ein Sieb 6 gedrückt wird, welches anschlie-ßend, wie in Fig. 2 unten veranschaulicht, abgehoben wird. Schließlich kann das Ausgangsmaterial 3 bei anderen Ausführungen des Verfahrens auch durch Gießen oder Laminieren auf die Folie 1 aufgebracht und mit dieser haftend verbunden werden, beispielsweise indem das Ausgangsmaterial 3 in Form von Pulver oder in Folienform auf die leitende Folie 1 aufgelegt und, beispielsweise mittels einer Walze (durch Rollenlaminieren) unter Einwirkung von Druck und Temperatur mit der leitenden Folie 1 verbunden wird. Je nach Zusammensetzung des Ausgangsmaterials 3, das auch aus mehreren Komponenten bestehen kann, kann ein Aushärten zur Bildung der dehnbaren Substratschicht 5 durch Einwirkung von Wärme oder auch chemisch ausgelöst werden.

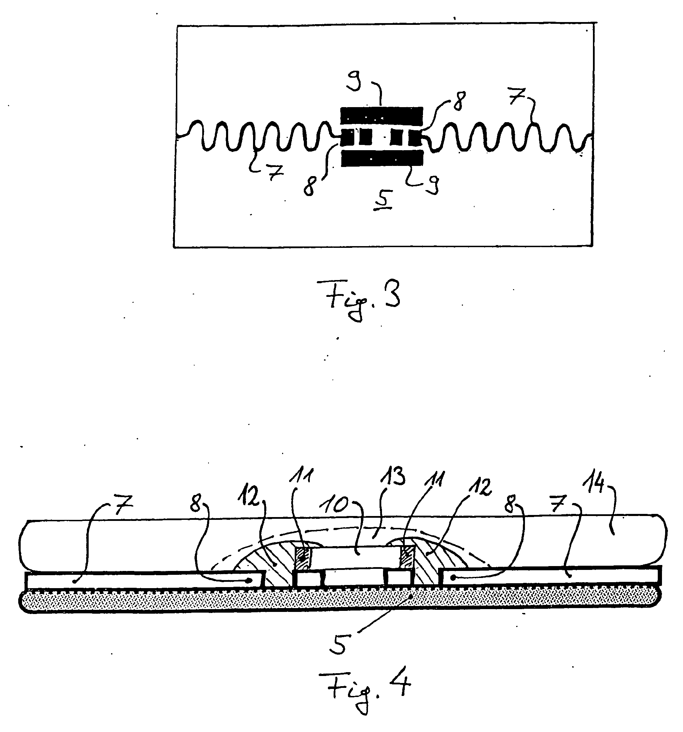

In einem weiteren Verfahrensschritt, dessen Ergebnis in Fig. 3 in Form einer Aufsicht auf den entstehenden Schaltungsträger dargestellt ist, wird die Folie 1 durch Photolithographie oder ein anderes geeignetes Verfahren so strukturiert, dass sie eine Leiterstruktur mit dehnbaren Leiterbahnen 7 bildet, die jeweils mit einer Anschlussfläche 8 verbunden sind. Eine Dehnbarkeit der Leiterbahnen 7 wird dabei dadurch erreicht, dass diese mit einem mäander- oder wellenförmigen Verlauf gebildet werden und dadurch eine Überlänge haben aufgrund derer sie sich unter Zugspannung ohne Bruch verlängern lassen. Ebenfalls zu erkennen sind Verstärkungsstrukturen 9, die beim Strukturieren aus der leitenden Folie 1 gebildet wurden und die die Substratschicht und damit den entstehenden dehnbaren Schaltungsträger in einer Umgebung der Anschlussflächen 8 versteifen. Die Versteifungsstrukturen 9 sind dabei als von den Leiterbahnen 7 und den Anschlussflächen 8 isolierte Versteifungsflächen (Versteifungspads) ausgeführt sind, die einen Abstand zwischen den Anschlussflächen 8 überbrücken, ohne diese zu berühren, wobei die zwei Anschlussflächen 8 zwischen zwei solchen Versteifungspads liegen.

Anschließend wird die Leiterstruktur mit einem in der Fig. 4 erkennbaren elektronischen Bauelement 10 bestückt, bei dem es sich um einen Sensor, einen integrierten Schaltkreis oder ein oberflächenmontiertes Bauelement (SMD) handeln kann. Es wäre möglich, dieses elektronische Bauelement 10 in an sich bekannter Weise direkt auf den Anschlussflächen 8 zu montieren, beispielsweise mit Hilfe eines leitfähigen Klebstoffs. Im vorliegenden Ausführungsbeispiel wird das elektronische Bauelement 10 jedoch zunächst auf zwei zusätzlichen Flächen, die beim Strukturieren der Folie 1 stehengelassen wurden, befestigt, wonach Anschlüsse 11 des elektronischen Bauelements 10 mittels eines leitfähigen dehnbaren Materials 12, im vorliegenden Beispiel ein mit leitfähigen Partikeln oder Fasern gefüllter Kunststoff, mit den Anschlussflächen 8 verbunden werden.

Im Anschluss daran wird das elektronische Bauelement 10 mit einem weiteren Material 13 umgeben, bei dem es sich um einen Polymeren Werkstoff handelt, der über das elektronische Bauelement 10 gegossen wird und nach einem Aushärten steifer ist als die dehnbare Substratschicht 5. In einem letzten Verfahrensschritt wird schließlich eine das elektronische Bauelement 10 und die Leiterstruktur mit den Leiterbahnen 7 und den Anschlussflächen 8 überdeckende zweite dehnbare Schicht 14 aufgebracht, die hier wieder aus einem thermoplastischen Polyurethan gebildet wird, das bei einer Temperatur von höchstens 130° C in verflüssigter Form aufgetragen werden kann, ohne das elektronische Bauelement 10 und dessen Kontaktierungen zu zerstören. Demgegenüber hat das im vorliegenden Beispiel verwendete Ausgangsmaterial 3 eine Schmelztemperatur von etwa 200° C, so dass auch die dehnbare Substratschicht 5 beim Aufbringen der zweiten dehnbaren Schicht 14 nicht verfließt. In beschriebener Weise ist ein dehnbarer Schaltungsträger entstanden, der sich problemlos auch mehrfach auf eine Länge von etwa 150 % einer Ausgangslänge ausdehnen und wieder auf die Ausgangslänge entspannen lässt.

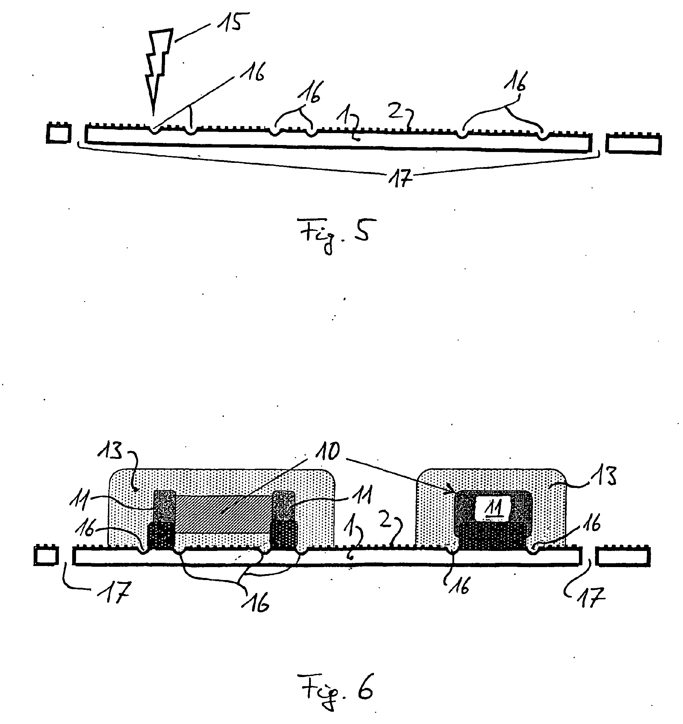

Auch bei dem in den Fign. 5 bis 8 veranschaulichten Verfahren wird ein dehnbarer Schaltungsträger hergestellt, der elektronische Bauelemente 10 umfasst und so ein autonomes elektronisches Gesamtsystem bildet. Wiederkehrende Merkmale sind in den Fign. 5 bis 8 wieder mit denselben Bezugszeichen versehen und haben vergleichbare Eigenschaften, sofern nichts anderes ausdrücklich erwähnt wird.

Bei diesem Verfahren wird die Folie 1 zunächst durch Einwirkung mit Laserstrahlung 15 mit Positionsmarkierungen 16, die durch Vertiefungen gegeben sind, sowie mit Orientierungsbohrungen 17 versehen. Dieser Verfahrensschritt ist in Fig. 5 veranschaulicht. Anschließend werden elektronische Bauelemente 10, die hier in SMD-Bauform vorliegen, mit Anschlüssen 11 an den Positionsmarkierungen 16 und damit auch in definierter Position relativ zu den Orientierungsbohrungen 17 auf der leitenden Folie 1 angeordnet und im vorliegenden Beispiel durch Löten mit der Folie 1 verbunden. Selbstverständlich können die elektronischen Bauelemente 10 stattdessen auch beispielsweise durch Pressschweißen, Diffusionsbonden oder Kleben mittels eines leitfähigen Klebstoffs mit der Folie 1 verbunden werden. Die so mit der Folie 1 verbundenen elektronischen Bauelemente 10 werden dann mit einem Polymerem Material 13 umgeben und dadurch auch mechanisch stabil auf der Folie 1 fixiert.

Anschließend wird in ähnlicher Weise, wie zuvor anhand der Fign. 1 und 2 beschrieben, ein Ausgangsmaterial 3 für ein dehnbares Substrat so auf die Folie 1 aufgebracht, dass die Folie 1 vollflächig abgedeckt wird und die elektronischen Bauelemente 10 vollständig eingebettet werden.

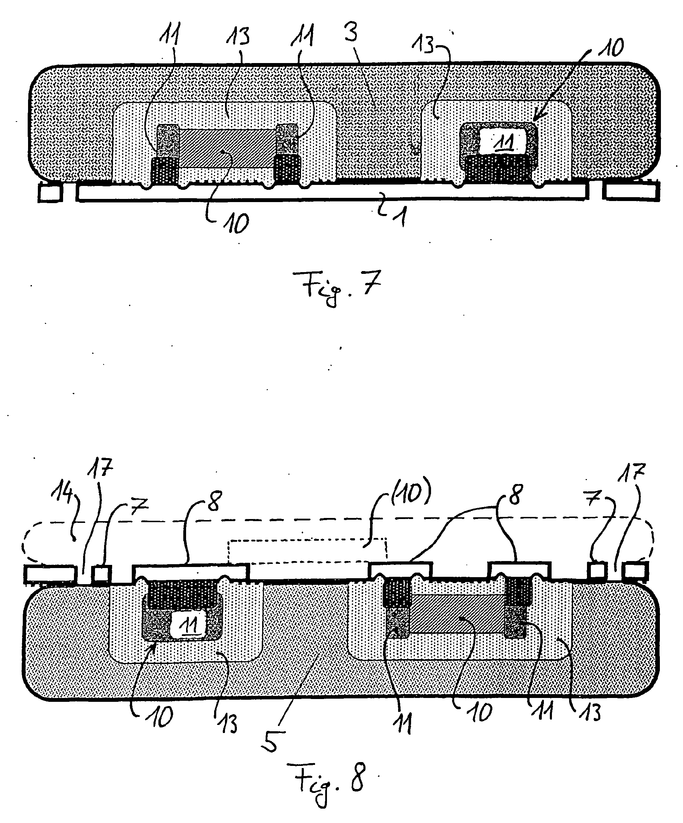

So entsteht nach einem Aushärten des Ausgangsmaterials 3 eine dehnbare Substratschicht 5, die hier eine Dicke von etwa 100 µm hat, wobei im Vergleich zu dieser dehnbaren Substratschicht 5 das die elektronischen Bauelemente 10 umgebende Material 13 steifer ist. Die Folie 1 wirkt nun wieder in an sich bekannter Weise, also beispielsweise durch Photolithographie, so strukturiert, dass sie eine Leiterstruktur mit dehnbaren Leiterbahnen 7 und Anschlussflächen 8 bildet, wobei die Orientierungsbohrungen 15 als Orientierungen dienen, in dem die wieder mäanderförmig geführten Leiterbahnen 7 und die Anschlussflächen 8 in definierter Position relativ zu den Orientierungsbohrungen 17 angeordnet werden. Bei einer Weiterentwicklung des Verfahrens wäre es auch denkbar zur Kontaktierung der elektronischen Bauelemente 10 wieder zusätzlich, wie in Fig. 4 veranschaulicht, ein leitfähiges dehnbares Material 12 zu verwenden, das die Anschlüsse 11 der elektronischen Bauteile 10 mit den Anschlussflächen 8 verbindet und das vor einem Auftragen des steiferen Materials 13 oder nach einem Strukturieren der Folie 1 lokal aufgebracht werden könnte. In einem letzten Verfahrensschritt wird nun wieder eine in Fig. 8 gestrichelt dargestellte zweite dehnbare Schicht 14 aufgebracht, wonach die Leiterstruktur in ein jetzt die dehnbare Substratschicht 5 und die zweite dehnbare Schicht 14 umfassendes dehnbares Substrat eingebettet ist.

Schließlich wäre es auch denkbar, das anhand der Fign. 1 bis 4 beschriebene Verfahren so mit dem anhand der Fign. 5 bis 8 beschriebenen Verfahren zu kombinieren, dass bei letzterem vor dem Auftragen der zweiten dehnbaren Schicht 14 auch noch an einer der dehnbaren Substratschicht 5 abgewandten Seite der Folie 1 mindestens ein weiteres elektronisches Bauelement (10) auf der Leiterstruktur montiert wird, das in Fig. 8 mit einer gepunkteten Umrisslinie dargestellt ist.

In Fig. 8 ist also ein in beschriebener Weise herstellbarer dehnbarer Schaltungsträger gezeigt, bei dem es sich beispielsweise um ein autonomes elektronisches System mit Sensorfunktion für medizintechnische Anwendungen handeln kann.

Mit der vorliegenden Erfindung wird also ein vorteilhaft einfaches Verfahren zum Herstellen eines dehnbaren Schaltungsträgers vorgeschlagen, bei dem eine Leiterstruktur mit einer dehnbaren Substratschicht verbunden wird, wobei die Leiterstruktur so gebildet wird, dass sie dehnbare Leiterbahnen sowie jeweils mit einer der dehnbaren Leiterbahnen verbundene Anschlussflächen für mindestens ein elektronisches Bauelement umfasst. Dabei sieht eine bevorzugte Ausführung der Erfindung vor, dass zur Bildung der dehnbaren Substratschicht ein Ausgangsmaterial für die Substratschicht auf eine elektrisch leitende Folie aufgebracht und mit der Folie verbunden wird, wonach die Folie so strukturiert wird, dass sie die Leiterstruktur bildet, wobei außerdem Verstärkungsstrukturen in die Folie einstrukturiert werden, die die Substratschicht in einer Umgebung von mindestens zwei Anschlussflächen versteifen, ohne die Anschlussflächen elektrisch miteinander zu verbinden, dadurch lässt sich in einfacher Weise verhindern, dass eine elektrische Kontaktierung eines auf den Anschlussflächen montierten elektronischen Bauelements bei einem Dehnen oder Entspannen des Schaltungsträgers Schaden nimmt.

Ein dementsprechend vorteilhafter dehnbarer Schaltungsträger, der sich mit diesem Verfahren herstellen lässt, umfasst ein dehnbares Substrat, eine in das Substrat eingebettete oder an einer Oberfläche des Substrats angeordnete Leiterstruktur mit dehnbaren Leiterbahnen und mindestens zwei jeweils mit einer der Leiterbahnen verbundenen Anschlussflächen sowie mindestens ein elektronisches Bauelement, das mit den Anschlussflächen elektrisch leitend verbundene Anschlüsse aufweist, wobei die Leiterstruktur in einer Ebene mit den Leiterbahnen liegende und aus dem gleichen Material wie die Leiterbahnen gebildete Verstärkungsstrukturen aufweist, die den Schaltungsträger in einer Umgebung der mit dem mindestens einen elektronischen Bauelement verbundenen Anschlussflächen versteifen, ohne die Anschlussflächen elektrisch leitend miteinander zu verbinden. Der Begriff "Schaltungsträger" sei dabei so allgemein verstanden, dass er auch - hier dehnbare - Schaltungen umfasst, die zusätzlich zu einer dehnbaren Leiterplatte darauf montierte oder integrierte elektronische Bauelemente aufweisen.

## Patentansprüche

1. Verfahren zum Herstellen eines dehnbaren Schaltungsträgers, bei dem ein Ausgangsmaterial (3) für ein dehnbares Substrat auf eine elektrisch leitende Folie (1) aufgebracht wird, das eine mit der Folie (1) verbundene dehnbare Substratschicht (5) bildet, wonach die Folie (1) so strukturiert wird, dass sie eine Leiterstruktur mit mindestens einer dehnbaren Leiterbahn (7) bildet, **dadurch gekennzeichnet, dass** die Leiterstruktur Anschlussflächen (8) umfasst, die jeweils mit einer dehnbaren Leiterbahn (7) verbunden sind, und wobei in die Folie (1) außerdem Verstärkungsstrukturen (9) einstrukturiert werden, die die Substratschicht (5) in einer Umgebung von mindestens zwei Anschlussflächen (8) versteifen, ohne die Anschlussflächen (8) elektrisch miteinander zu verbinden.

2. Verfahren nach Anspruch 1, **dadurch gekennzeichnet, dass** die mindestens eine Leiterbahn (7) einen alternierend in einander gegenüberliegende Richtungen aus einer Hauptleiterrichtung heraus gekrümmten Verlauf erhält.

3. Verfahren nach einem der Ansprüche 1 oder 2, **dadurch gekennzeichnet, dass** die leitende Folie (1) eine Dicke von zwischen 5 µm und 100 µm hat und/oder aus Kupfer oder Silber oder Gold gebildet ist.

4. Verfahren nach einem der Ansprüche 1 bis 3, **dadurch gekennzeichnet, dass** die Folie (1) vor dem Auftragen des Ausgangsmaterials (3) an einer später der dehnbaren Substratschicht (5) zugewandten Oberfläche (2) aufgerauht oder oxidiert wird.

5. Verfahren nach einem der Ansprüche 1 bis 4, **dadurch gekennzeichnet, dass** die dehnbare Substratschicht (5) aus einem Polyurethan oder Silikon oder Kautschuk oder Latex gebildet wird.

6. Verfahren nach einem der Ansprüche 1 bis 5, **dadurch gekennzeichnet, dass** die dehnbare Substratschicht (5) eine Dicke von zwischen 25 µm und 1 mm hat.

7. Verfahren nach einem der Ansprüche 1 bis 6, **dadurch gekennzeichnet, dass** das Ausgangsmaterial (3) durch Drucken oder Rakeln oder Gießen oder Laminieren auf die Folie (1) aufgebracht wird.

8. Verfahren nach einem der Ansprüche 1 bis 7, **dadurch gekennzeichnet, dass** nach dem Strukturieren der Folie (1) eine die Leiterstruktur überdeckende zweite dehnbare Schicht (14) aufgebracht wird.

9. Verfahren nach einem der Ansprüche 1 bis 8, **dadurch gekennzeichnet, dass** die Leiterstruktur nach dem Strukturieren der Folie (1) mit mindestens einem elektronischen Bauelement (10) bestückt wird.

10. Verfahren nach Anspruch 9, **dadurch gekennzeichnet, dass** das elektronische Bauelement (10) anschließend mit einem Material (13) umgeben wird, das steifer ist als die dehnbare Substratschicht (5) .

11. Verfahren nach einem der Ansprüche 9 oder 10, sofern diese sich auf Anspruch 8 beziehen, **dadurch gekennzeichnet, dass** die zweite dehnbare Schicht (14) bei einer niedrigen Temperatur aufgebracht wird als das die dehnbare Substratschicht (5) bildende Ausgangsmaterial (3).

12. Verfahren nach einem der Ansprüche 1 bis 8, **dadurch gekennzeichnet, dass** vor dem Aufbringen des Ausgangsmaterials (3) mindestens ein elektronisches Bauelement (10) auf der Folie (1) angeordnet und mit der Folie (1) verbunden wird, wobei das mindestens eine elektronische Bauelement (10) beim Aufbringen des Ausgangsmaterials (3) in die entstehende dehnbare Substratschicht (5) eingebettet wird.

13. Verfahren nach Anspruch 12, **dadurch gekennzeichnet, dass** das mindestens eine auf der Folie (1) angeordnete elektronische Bauelement (10) vor dem Aufbringen des Ausgangsmaterials (3) mit einem Material (13) umgeben wird, der steifer ist als die dehnbare Substratschicht (5).

14. Verfahren nach einem der Ansprüche 12 oder 13, **dadurch gekennzeichnet, dass** die Folie (1) vor dem Anordnen des mindestens einen elektronischen Bauelements (10) auf der Folie (1) mit Positionsmarkierungen (16) und/oder Orientierungsbohrungen (17) versehen wird, wonach das mindestens eine elektronische Bauelement (10) an den Postionsmarkierungen (16) und/oder in definitiv Position relativ zu den Orientierungsbohrungen. (17) angeordnet wird.

15. Verfahren nach einem der Ansprüche 9 bis 14, **dadurch gekennzeichnet, dass** Anschlüsse (11) des mindestens einen elektronischen Bauelements (10) mittels eines leitfähigen dehnbaren Materials (12) mit Anschlussflächen (8) der Leiterstruktur verbunden werden.

16. Verfahren nach einem der Ansprüche 9 bis 15, **dadurch gekennzeichnet, dass** das mindestens eine elektrische Bauelement (10) an der Folie (1) oder an der Leiterstruktur angelötet wird.

17. Dehnbarer Schaltungsträger, umfassend ein dehnbares Substrat, eine in das Substrat eingebettete oder an einer Oberfläche des Substrats angeordnete Leiterstruktur mit dehnbaren Leiterbahnen (7) und mindestens zwei jeweils mit einer der Leiterbahnen (7) verbundenen Anschlussflächen (8) sowie mindestens ein elektronisches Bauelement (10), das mit den Anschlussflächen (8) elektrisch leitend verbundene Anschlüsse (11) aufweist,
**dadurch gekennzeichnet,**
**dass** die Leiterstruktur Verstärkungsstrukturen (9) aufweist, die den Schaltungsträger in einer Umgebung der mit dem mindestens einen elektronischen Bauelement (10) verbundenen Anschlussflächen (8) versteifen, ohne die Anschlussflächen (8) elektrisch leitend miteinander zu verbinden.

18. Dehnbarer Schaltungsträger nach Anspruch 17, **dadurch gekennzeichnet,**
**dass**
- das mindestens eine elektronische Bauelement (10) mit einem es mechanisch mit der Leiterstruktur verbindenden Material (13) umgeben ist, das steifer ist als ein das dehnbare Substrat bildenden Material,
und/oder
- mindestens einer der Anschlüsse (11) des mindestens einen elektronischen Bauteils (10) mittels eines leitfähigen dehnbaren Materials (12) mit der entsprechenden Anschlussfläche (8) verbunden ist.

19. Dehnbare Schaltungsträger nach einem der Ansprüche 17 oder 18, herstellbar nach einem der Ansprüche 1 bis 16.

## Claims

1. A method for manufacturing an extensible circuit carrier, with which a starting material (3) for an extensible substrate is deposited onto an electrically conductive foil (1) and forms an extensible substrate layer (5) connected to the foil (1), whereupon the foil (1) is structured such that it forms a conductor structure with at least one extensible strip conductor (7), **characterised in that** the conductor structure comprises connection surfaces (8) which are each connected to an extensible strip conductor (7), and wherein moreover reinforcement structures (9) are structured into the foil (1) and these reinforcement structures stiffen the substrate layer (5) in an environment of at least two connection surfaces (8), without electrically connecting the connection surfaces (8) to one another.

2. A method according to claim 1, **characterised in that** the at least one strip conductor (7) obtains a course which is curved in an alternating manner, in directions opposite one another, out of a main conductor direction.

3. A method according to one of the claims 1 or 2, **characterised in that** the conductive foil (1) has a thickness of between 5 µm and 100 µm and/or is formed from copper or silver or gold.

4. A method according to one of the claims 1 to 3, **characterised in that** the foil (1) is roughened or oxidised before the deposition of the starting material (3) on surface (2) which later faces the extensible substrate layer (5).

5. A method according to one of the claims 1 to 4, **characterised in that** the extensible substrate layer (5) is formed from a polyurethane or silicone or rubber or latex.

6. A method according to one of the claims 1 to 5, **characterised in that** the extensible substrate (5) has a thickness of between 25 µm and 1 mm.

7. A method according to one of the claims 1 to 6, **characterised in that** the starting material (3) is deposited onto the foil (1) by way of printing or doctoring or moulding/casting or laminating.

8. A method according to one of the claims 1 to 7, **characterised in that** a second extensible layer (14) which covers the conductor structure is deposited after the structuring of the foil (1).

9. A method according to one of the claims 1 to 8, **characterised in that** the conductor structure after the structuring of the foil (1) is provided with at least one electronic component (10).

10. A method according to claim 9, **characterised in that** the electronic component (10) is subsequently surrounded by a material (13) which is stiffer than the extensible substrate layer (5)

11. A method according to one of the claims 9 or 10, inasmuch as these relate to claim 8, **characterised in that** the second extensible layer (14) is deposited at a lower temperature than the starting material (3) forming the extensible substrate layer (5).

12. A method according to one of the claims 1 to 8, **characterised in that** at least one electronic component (10) is arranged on the foil (1) and is connected to the foil (1), before depositing starting material (3), wherein the at least one electronic component (10) is embedded into the arising extensible substrate layer (5) on depositing the starting material (3).

13. A method according to claim 12, **characterised in that** the at least one electronic component (10) arranged on the foil (1), before the deposition of the starting material (3) is surrounded by a material (13) which is stiffer than the extensible substrate layer (5).

14. A method according to one of the claims 12 or 13, **characterised in that** the foil (1) before the arrangement of the at least one electronic component (10) on the foil (1) is provided with positioning markings (16) and/or orientation bores (17), whereupon the at least one electronic component (10) is arranged on the position markings (16) and/or in definitive positions relative to the orientation bores (17).

15. A method according to one of the claims 9 to 14, **characterised in that** connections (11) of the at least one electronic component (10) are connected to connection surfaces (8) of the conductor structure by way of a conductive extensible material (12).

16. A method according to one of the claims 9 to 15, **characterised in that** the at least one electrical component (10) is soldered on the foil (1) or on the conductor structure.

17. An extensible circuit carrier, comprising an extensible substrate, a conductor structure with extensible strip conductors (7) and with at least two connections surfaces (8) which are each connected to one of the strip conductors (7), said conductor structure being embedded into the substrate or arranged on a surface of the substrate, and as well as at least one electronic component (10) which comprises connections (11) which are electrically conductively connected to the connection surfaces (8),
**characterised in that**,
the conductor structure comprises reinforcement structures (9) which stiffen the circuit carrier in an environment of the connection surfaces (8) connected to the at least one electronic component (10), without electrically connecting the connection surfaces (8) to one another.

18. An extensible circuit carrier according to claim 17, **characterised in that**
the at least one electronic component (10) is surrounded by a material (13) which mechanically connects it to the conductor structure and which is stiffer that a material forming the extensible substrate
and/or
at least one of the connections (11) of the at least one electronic component (10) is connected to the respective connection surface (8) by way of a conductive, extensible material (12).

19. An extensible circuit carrier according to one of the claims 17 or 18, manufacturable according to one of the claims 1 to 16.

## Revendications

1. Procédé de fabrication d'un support de circuit étirable, dans lequel un matériau de départ (3) est appliqué pour un substrat étirable sur un film électroconducteur (1), qui forme une couche de substrat étirable (5) reliée au film (1), le film (1) étant ensuite structuré de sorte qu'il forme une structure conductrice présentant au moins une piste conductrice étirable (7), **caractérisé en ce que** la structure conductrice comprend des surfaces de raccordement (8), qui sont reliées respectivement à une piste conductrice étirable (7) et des structures de renforcement (9) étant en outre intégrées dans le film (1), qui rigidifient la couche de substrat (5) autour d'au moins deux surfaces de raccordement (8) sans relier électriquement entre elles les surfaces de raccordement (8).

2. Procédé selon la revendication 1, **caractérisé en ce que** l'au moins une piste conductrice (7) reçoit une forme incurvée alternativement dans des directions opposées entre elles à partir d'une direction principale de conducteur.

3. Procédé selon l'une quelconque des revendications 1 ou 2, **caractérisé en ce que** le film conducteur (1) présente une épaisseur comprise entre 5 µm et 100 µm et/ou est fabriqué en cuivre, en argent ou en or.

4. Procédé selon l'une quelconque des revendications 1 à 3, **caractérisé en ce que** le film (1) est rendu rugueux ou oxydée avant l'application du matériau de départ (3) sur une surface (2) orientée ultérieurement vers la couche de substrat étirable (5).

5. Procédé selon l'une quelconque des revendications 1 à 4, **caractérisé en ce que** la couche de substrat étirable (5) est fabriquée en polyuréthane, en silicone, en caoutchouc ou en latex.

6. Procédé selon l'une quelconque des revendications 1 à 5, **caractérisé en ce que** la couche de substrat étirable (5) présente une épaisseur comprise entre 25 µm et 1 mm.

7. Procédé selon l'une quelconque des revendications 1 à 6, **caractérisé en ce que** le matériau de départ (3) est appliquée sur le film (1) par pression, raclage, moulage ou lainage.

8. Procédé selon l'une quelconque des revendications 1 à 7, **caractérisé en ce qu'**une deuxième couche étirable (14) recouvrant la structure conductrice est appliquée après la structuration du film (1).

9. Procédé selon l'une quelconque des revendications 1 à 8, **caractérisé en ce que** la structure conductrice est équipée, après la structuration du film (1), d'au moins un composant électronique (10).

10. Procédé selon la revendication 9, **caractérisé en ce que** le composant électronique (10) est ensuite entouré d'un matériau (13) qui est plus rigide que la couche de substrat étirable (5).

11. Procédé selon l'une quelconque des revendications 9 ou 10, dans la mesure ou elles se réfèrent à la revendication 8, **caractérisé en ce que** la deuxième couche étirable (14) est appliquée à une température plus basse que le matériau de départ (3) formant la couche de substrat étirable (5).

12. Procédé selon l'une quelconque des revendications 1 à 8, **caractérisé en ce que**, avant l'application du matériau de départ (3) au moins un composant électronique (10) est disposé sur le film (1) et relié au film (1), l'au moins un composant électronique (10) étant encastré dans la couche de substrat étirable (5) se formant lors de l'application du matériau de départ (3).

13. Procédé selon la revendication 12, **caractérisé en ce que** l'au moins un composant électronique (10) disposé sur le film (1) est entourée, avant l'application du matériau de départ (3), d'un matériau (13) qui est plus rigide que la couche de substrat étirable (5).

14. Procédé selon l'une quelconque des revendications 12 ou 13, **caractérisé en ce que** le film (1) est muni, avant la disposition de l'au moins un composant électronique (10) sur le film (1), de marquages de positionnement (16) et/ou de perçages d'orientation (17), l'au moins un composant électronique (10) étant ensuite disposé au niveau des marquages de positionnement (16) et/ou dans une position définitive par rapport aux perçages d'orientation (17).

15. Procédé selon l'une quelconque des revendications 9 à 14, **caractérisé en ce que** les raccordements (11) de l'au moins un composant électronique (10) sont reliés aux surfaces de raccordement (8) de la structure conductrice au moyen d'au moins un matériau conducteur étirable (12).

16. Procédé selon l'une quelconque des revendications 9 à 15, **caractérisé en ce que** l'au moins un composant électrique (10) est soudé au film (1) ou à la structure conductrice.

17. Support de circuit étirable comprenant un substrat étirable, une structure conductrice encastrée dans le substrat ou disposé sur une surface du substrat, présentant des pistes conductrices (7) et au moins deux surfaces de raccordement (8) reliées respectivement à l'une des pistes conductrices (7) ainsi qu'au moins un composant électronique (10) qui présente des raccordements (11) reliés de manière électro-conductrice aux surfaces de raccordement (8),
**caractérisé en ce que**
la structure conductrice présente des structures de renforcement (9) qui rigidifient le support de circuit autour des surfaces de raccordement (8) reliées à l'au moins un composant électronique (10) sans relier les surfaces de raccordement (8) de manière électro-conductrice entre elles.

18. Support de circuit étirable selon la revendication 17, **caractérisé en ce que**
- l'au moins un composant électronique (10) est entouré d'un matériau (13) qui le relie mécaniquement à la structure conductrice et qui est plus rigide qu'un matériau formant le substrat étirable,
et/ou
- au moins un des raccordements (11) de l'au moins un composant électronique (10) est relié avec la surface de raccordement (8) correspondante au moyen d'un matériau conducteur étirable (12).

19. Support de circuit étirable selon l'une quelconque des revendications 17 ou 18, pouvant être fabriqué selon l'une des revendications 1 à 16.
